# EUROPEAN PATENT APPLICATION

(11) **EP 1 508 967 A1**
(43) Date of publication of application: **23.02.2005**
(21) Application number: 04012812.6
(22) Date of filing: 28.05.2004
(51) Int. Cl.: H03G 3/30

(54) **A power amplifier module and a mobile terminal**

(71) Applicant: SIEMENS AKTIENGESELLSCHAFT, 80333 München (DE)
(72) Inventor: Langer, Andreas, 85716 Unterschleissheim-Lohhof (DE); Gretzer, Ulrich, 81479 München (DE)

(57) **Abstract**

A power amplifier module (201; 301) comprises an amplifier circuit (103) responsive to a ramp voltage (V_{RAMP}), for amplifying an input signal (IS) to an output signal (OS), means (223; 325) for receiving digital ramp information (DRI) corresponding to a power ramp, and digital-to-analog converting means (121), responsive to the means (223, 325) for receiving digital ramp information (DRI), for controlling the amplifier circuit (103) by setting the ramp voltage (V_{RAMP}).

A mobile terminal (10) comprises a base band unit (213) electrically connected to the power amplifier module (201), a power amplifier module (201), an antenna (107) electrically connected to the power amplifier module (201). The base band unit (213) is adapted to pass information (BAND, PCL; DRI) responsive to channel frequency (BAND) and power class (PCL) to the power amplifier module (201).

## Description

### Field of the invention

The invention relates in general to power control in general, and, more specifically, to a power amplifier module and a mobile terminal comprising a power amplifier module.

### Background of the invention

In mobile communications, power amplifiers are used to amplify microwave signal.

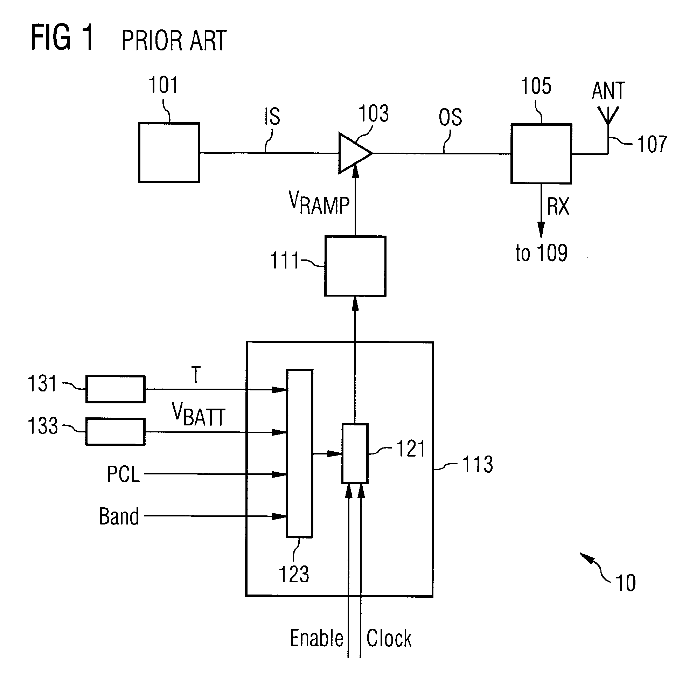

Figure 1 shows a prior art mobile terminal 10. The power amplifier circuit 103 is adapted to amplify an input signal IS received from the radio frequency subsystem 101 to an output signal OS. The output signal OS is fed through a front-end module 105 to an antenna 107. In contrast to signal transmitted by the antenna 107, the signal received by it is passed through the front-end module 105 to receiver 109.

The transmitting of data is usually done in bursts. A burst has a finite duration. In the beginning of a burst, the power amplifier circuit 103 is ramped up by changing the control voltage V_{RAMP}. It is advantageous if the transmitting power can be sustained during the burst. At the end of the burst the power amplifier circuit 103 is ramped down by changing the control voltage V_{RAMP} in the opposite direction.

Since the technical specifications in different mobile network standards set strict requirements to transmitter performance, careful consideration is necessary when designing the power ramps, especially regarding output power and allowed transient spectrum.

The ramping in the power amplifier circuit 103 is performed so that the base band chipset 113 selects a correct ramp from ramps contained therein. The ramps are stored digitally, and factors contributing to the selection of the ramp include temperature T, supply voltage V_{BATT}, power class PCL and channel frequency BAND that is used.

The temperature T is measured with a temperature sensor 131, and the supply voltage V_{BATT} is measured with a voltage sensor 133. Typically the temperature sensor 131 and voltage sensor 133 produce an output that is digitized by an internal analog-to-digital converter.

The base band chipset 113 obtains the power class PCL and channel frequency BAND usually from the mobile network.

The memory unit 123 in the base band chipset 113 comprises information for setting the power ramps. The power amplifier circuit 103 is controlled by the base band chipset 113. In this sense the power amplifier circuit 103 is responsive to ramp voltage V_{RAMP}. Furthermore, the digital-to-analog converter DAC 121 is responsive to clock signal CLOCK and enabling signal ENABLE which DAC 121 obtains through the base band chipset 113.

A problem of the prior art design is that it is very laborous to replace a power amplifier of a first manufacturer with a power amplifier of a second manufacturer since the design of the ramps is tedious and time-consuming. Similar problems apply when a specific power amplifier model of a manufacturer is changed to another model of the same manufacturer.

### Summary of the invention

A first objective of the invention is to enable simplifying the design of the base band chipset by outsourcing analog functionality (e.g. DAC Converter) and to enable better interchangeability of the power amplifiers. Achieving this objective can be facilitated by using a power amplifier module as set out in claim 1.

A second objective of the invention is to remove the task of ramping from the baseband chipset. Achieving this objective can be facilitated as set out in dependent claim 3.
A third objective of the invention is to reduce the effort needed in designing the base band chipset for a mobile terminal. This objective can be achieved with a mobile terminal of claim 8.

The dependent claims describe various advantageous embodiments of the invention.

### Advantages of the invention

If the power amplifier module comprises means for receiving digital ramp information corresponding to a power ramp and digital-to-analog converting means, responsive to the means for receiving digital ramp information, for controlling the power amplifier circuit by setting the ramp voltage, the design of the base band chipset can be made easier, since all analog functions can be removed from the base band chipset. Especially if the power amplifier module does not comprise only power ramps but it has also been calibrated against the output power, the power amplifier manufacturer can deliver power amplifiers that already by delivery comprise all compensated power ramps. The advantage of this embodiment is that the power compensation can be neglected in the design of the base band chipset.

Furthermore, the manufacturer of the power amplifier module can design power ramps that fulfil the requirements of the GSM specifications regarding the power and time template, transient spectrum, and monotony. Consequtively, development effort for the manufacturers of mobile terminals is reduced.

If the digital-to-analog converting means of the power amplifier module further comprise means for receiving a clock signal and the digital-to-analog converting means is responsive to the clock signal received, it can be ensured that the power ramp is set to the power amplifier circuit at the right moment in time.

If the power amplifier module further comprises a storage for storing digital ramp information for a plurality of power ramps, means for selecting digital ramp information for a power ramp from digital ramp information stored, and
means for passing the digital ramp information selected to the digital-to-analog converting means, the relevant power ramp can be selected by the target output power, temperature and power level and communicated to the memory of the power amplifier module.

If the power amplifier module further comprises means for measuring temperature and/or battery supply voltage, electrically connected to means for selecting digital ramp information; and if the means for selecting digital ramp information is responsive to temperature and/or battery supply voltage received from said means for measuring temperature and/or battery supply voltage, the corresponding functionality of the base band chipset can be omitted and the functionalities left over can be carried out in an ordinary processor unit.

If the power amplifier circuit, means for receiving digital ramp information corresponding to a power ramp, and digital-to-analog converting means are all integrated on a microchip the number of separate components can be reduced by means of integration.

If the microchip further comprises the storage for storing digital ramp information for a plurality of power ramps, the means for selecting digital ramp information, and the means for passing the digital ramp information to the digital-to-analog converting means, the number of separate components can be further reduced.

If the microchip further comprises the means for measuring temperature and/or battery supply voltage, the number of separate components can be further reduced.

If a mobile terminal which comprises a base band unit electrically connected to the power amplifier module, a power amplifier module according to the first or second objectives of the invention, and an antenna electrically connected to the power amplifier, and if the base band unit is adapted to pass information responsive to band information and power class information to the power amplifier module, the design of the mobile terminal becomes more modular and thus less time-consuming.

In another aspect of the second embodiment the power amplifier module may further comprise means for measuring the temperature and supply voltage. In this manner the power amplifier module needs only to know the desired output power. Depending on the current temperature and supply power the power amplifier module selects independently the relevant power ramp.

If the information responsive to channel frequency and power class does not comprise digital ramp information but comprises channel frequency and power class information, most functions of the base band chipset can be omitted and the baseband chipset can indeed be replaced with a normal processor unit.

If the information responsive to channel frequency and power class is digital ramp information, the design of the power amplifier module can be made less complex. Following this design option, the mobile terminal manufacturer has still the burden of providing suitable power ramps.

To summarize, the combined advantages of any of the embodiments are so revolutionary that the extra effort in designing the hardware of the power amplifier can be neglected. This is an answer to a long-felt need since power amplifier manufacturers have been looking for new embodiments in order to enlarge the functionality of the power amplifiers for many years.

### Short description of the drawings

In the following, the invention is described in more detail with reference to the examples in Figures 2 to 4 of the accompanying drawings, of which:
Figure 1 shows a simplified block diagram of a prior art mobile terminal;
Figure 2 shows a power amplifier module according to the first objective of the invention;
Figure 3 shows a power amplifier module according to the second objective of the invention; and
Figures 4A-4C illustrate the generation of a power ramp.

Same reference numerals refer to similar structural elements throughout the Figures.

### Detailed description of the invention

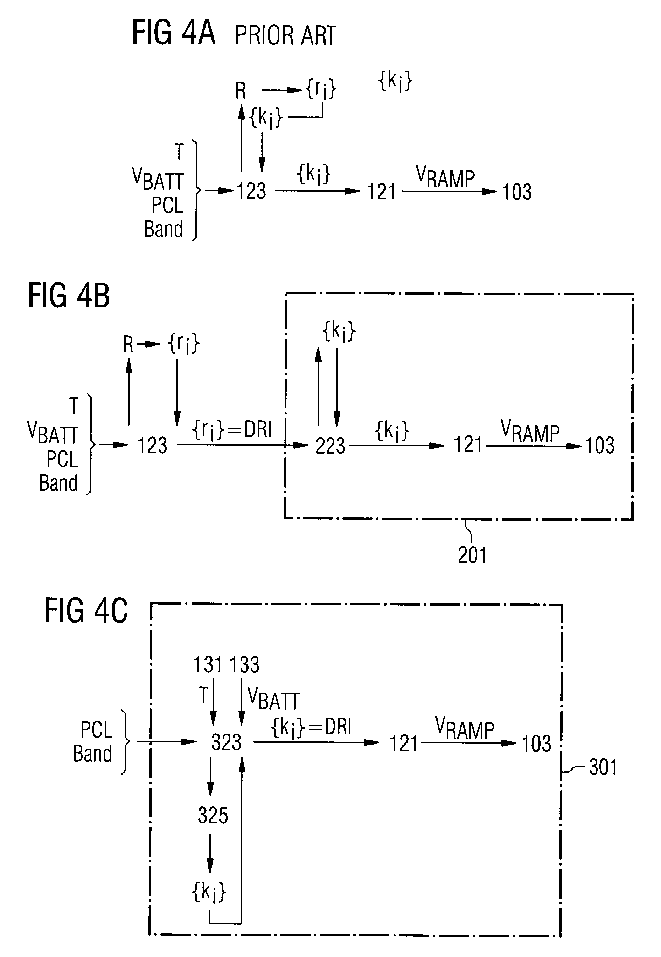

Figure 4A illustrates the generation of a a power ramp in a prior art mobile terminal 10. In the manner as described with reference to Figure 1 above, the input signal IS having an input power P_{IN} and comprising data to be transmitted is fed into the power amplifier circuit 103. The power amplifier circuit 103 amplifies the input signal IS to an output signal OS having an output power P_{OUT}, usually by feeding current obtained from a rechargeable battery (not shown in Figure 1) to a serie of transistors.

Because of transient considerations, the supply voltage V_{BATT} is not usually switched but the gain of the power amplifier circuit 103 is increased or decreased by applying a changing control voltage V_{RAMP}. This is one purpose for which the base band chipset 113 of a mobile terminal 10 has been used in prior art. This is known as ramping or setting of the power ramp.

An example of power values *r*_{*i*} of an up-ramp *R* is [in dBm] *r*_{*1*} = -50; *r*_{*2*} *=* -50; r₃ = -50; *r*_{*4*} = -50; *r*_{*5*} = -50; *r*_{*6*} = -50; *r*_{*7*} *=* -10; *r*_{*8*} = -5; *r*_{*9*} = 10; *r*_{*10*} = 15; *r*_{*11*} = 20; *r*_{*12*} = 25; *r*_{*13*} *=* 30; *r*_{*14*} = 32; *r*_{*15*} = 33; *r*_{*16*} *=* 33. The value of -50 dBm corresponds isolation by definition of the power values. With this ramp *R* the nominal value of power in a burst has to be 33 dBm. The shapes of up- and down-ramps *R* for each power class PCL are stored in memory unit 123 of the base band chipset 113. For every power class PCL there is at least one ramp *R* available.

Power values *r*_{*i*} of a ramp *R* cannot be passed to the power amplifier circuit 103 as such, because the power amplifier circuit 103 is adapted to receive a control voltage V_{RAMP} but not a power value *r*_{*i*}. In order to make a feasible digital-to-analog conversion in a digital-to-analog converter DAC 121, the power values *r*_{*i*} are mapped in the memory unit 123 to key values *k*_{*i*}. For example, if the DAC 121 is a 10-bit Digital-to-Analog Converter, the key value *k*_{*i*} obtains then any value between 0 and 1023, depending on the mapping schema used. The DAC 121 converts the key value *k*_{*i*} to a ramp voltage V_{RAMP}. The key value *k*_{*i*} = 1023 corresponds to a ramp voltage V_{RAMP} = 1.8 V, for example.

In consequence, a digital power ramp R is mapped by the memory unit 123 to a number of key values *k*_{*i*} which are then passed to the DAC 121. In some implementations, the number of key values *k*_{*i*} in a ramp *R* is 16. For the isolation (*r*_{*i*} = -50 dBm) a key value *k*_{*i*} = 0 is selected.

In up- or down-ramping, the ramp voltage V_{RAMP} of the power amplifier circuit 103 is set responsive to all key values *k*_{*i*} of the ramp *R*, the key values *k*_{*i*} following each other in even time intervals, e.g. every 1.8 µs. The control voltage V_{RAMP} corresponding to the last key value *k*_{*16*} of the up-ramp *R* is sustained. The data-carrying part of a burst begins after setting the last key value *k*_{*16*}*,* so the last key value *k*_{*16*} therefore defines the power in a burst. The form of the up- and down -ramps *R* can be controlled by selecting the key values *k*_{*i*} inside the ramps *R*. Because the power amplifier circuit 103 is affected by changes in its operating temperature T, supply voltage V_{BATT}, and channel frequency BAND, in order to maintain the performance, the ramps *R* are preferably not stored defined as key values *k*_{*i*} but as power values *r*_{*i*}, in the memory unit 123.

The mapping of power values *r*_{*i*} of an up- or down-ramp *R* to key values *k*_{*i*} is stored in the memory unit 123. Different mappings may be stored to be used in different environmental conditions, such as in different temperature T, different supply voltage V_{BATT}, and different channel frequency BAND. The power values *r*_{*i*} of an up- or down-ramp *R* are mapped to corresponding key values *k*_{*i*} in the memory unit 123.

For GSM systems, it is advantageous that the memory unit 123covers the range from -15 dBm to 33 dBm in 0.25 dB steps. For different temperatures and voltage ranges there may be separate mappings in the memory unit 123.

A current need is to change the mobile radio architecture so that the base band chipset 113 can be implemented digitally and all analogic functions of the high frequency transceiver or in the power management ASIC can be removed. The analogic functions that should be removed include the generation of the ramp for setting the desired output power and the generation of the AFC voltage.

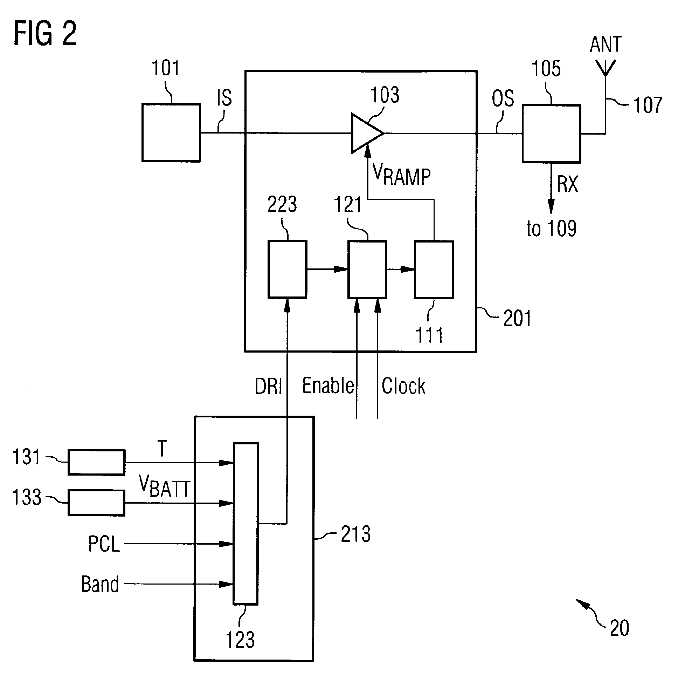

Figure 2 shows a power amplifier module 201 according to the first objective of the invention. The switching means necessary for the ramping (memory unit 223, DAC 121, and filter 111) are accommodated in the power amplifier module 201 together with the power amplifier circuit 103.

The power amplifier module 201 further comprises means for receiving digital ramp information DRI corresponding to a power ramp. An example of the means for receiving digital ramp information DRI corresponding to a power ramp is a memory unit 223. In the following description the embodiments are discussed in a non-limiting manner using this example.

The power amplifier module 201 further comprises digital-to-analog converting means 121, responsive to the memory unit 223 which comprises means for receiving digital ramp information DRI, for controlling the amplifier circuit 103 by setting the ramp voltage V_{RAMP}.

The power amplifier module 201 further comprises an input for the system clock CLOCK and at least one input for a triggering signal ENABLE, over which either the time of outputting the power ramp can be controlled or an internal sequencer is started that controls the ramping.

As shown in Figure 2, the base band chipset 213 passes the current ramp DRI as a digital word to the ramp memory unit 223 of the power amplifier module 201 before a burst is fed from the radio frequency subsystem 101 to the power amplifier circuit 103. After the release by the trigger signal ENABLE the ramp voltage V_{RAMP} is then output.

Figure 4B illustrates the generation of a power ramp using a power amplifier module 201 according to the first objective of the invention. The digital ramp information DRI corresponds to digital representation of a set {rᵢ} of power values that form a digital power ramp R. The memory unit 223 maps the set {rᵢ} of power values to the set {kᵢ} of key values.

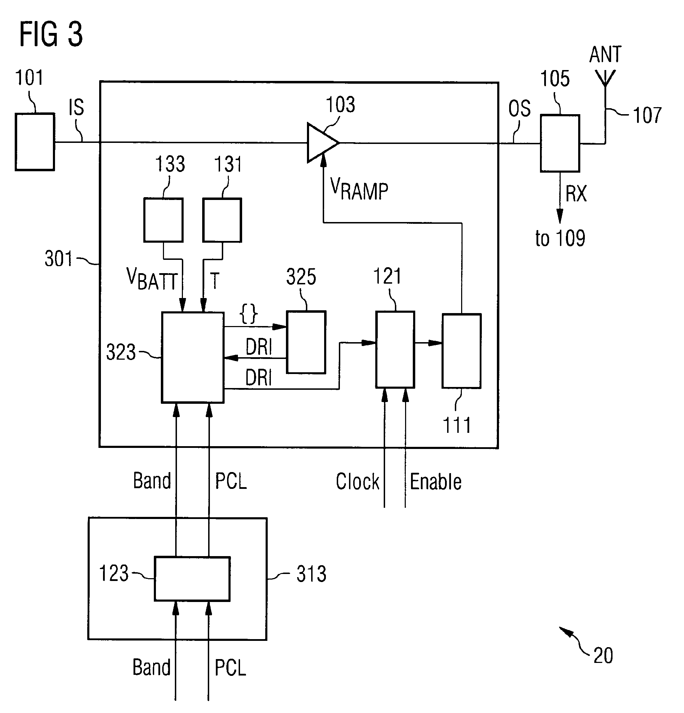

Figure 3 shows a power amplifier module 301 according to the second objective of the invention. The power amplifier module 301 is in many aspects very similar to the power amplifier module 201, with minor differences that are discussed below. The ramps R for all power levels, including also ramps for extreme conditions (temperature T and supply voltage V_{BATT}), are stored in the power amplifier module 301, especially in its means for selecting digital ramp information DRI. A non-limiting example of the means for selecting digital ramp information DRI is a memory unit 323. The power amplifier module 301 may further comprise means 131 for measuring temperature T and/or means 133 for measuring battery supply voltage V_{BATT}. The means 131 and/or 133 may be electrically connected to means for selecting digital ramp information DRI. The means, such as the memory unit 323 may then be responsive to temperature T and/or battery supply voltage V_{BATT} received from said means 131 and/or 133 for measuring temperature T and/or battery supply voltage V_{BATT}.

Figure 4C illustrates the generation of a power ramp using a power amplifier module 301 according to the second objective of the invention. The memory unit 323 receives power class PCL and channel frequency BAND from a processor unit 313. According to a further aspect of the invention, the memory unit 323 may further receive the temperature T from the temperature sensor 131 and/or the supply voltage V_{BATT} from the voltage sensor 133. The memory unit selects a digital power ramp R based on the power class PCL, the channel frequency BAND, the temperature T, and the supply voltage V_{BATT}.

The digital ramp information DRI corresponds to this digital power ramp R which comprises the digital representation of the set {rᵢ} of power values that form the power ramp R. The look-up table 325 maps the set {rᵢ} of power values to a set {kᵢ} of key values and returns the set {kᵢ} of key values to the memory unit 323.

It advantageous if the power amplifier module 201 or 301 further includes a test mode that enables using an external ramp output that is available through the digital interface and enables disabling the output which outputs the ramp to the front end 105. This feature is important for the testability during the development.

The complete front-end module 105, including the receiver surface-acoustic wave filters, may further be integrated into the power amplifier module 201 or 301.

Even though the examples have been discussed in relation to GSM only, for the skilled person it is clear that the invention is not limited to this particular mobile communication system but can be carried out in any devices suitable for use in a mobile communication network wherein power ramping is used.

### List of used reference numerals

- 10: mobile terminal
- 20: mobile terminal
- 101: radio frequency subsystem
- 103: power amplifier circuit
- 105: front-end module
- 107: antenna
- 109: receiver
- 111: filter
- 113: base band chipset
- 121: digital-to-analog converter DAC
- 123: memory unit
- 131: temperature sensor
- 133: voltage sensor
- 201: power amplifier module
- 213: base band chipset
- 223: means for receiving digital ramp information, such as a memory unit
- 301: power amplifier module
- 313: processor unit
- 323: means for selecting digital ramp information DRI, such as a memory unit
- 325: means for receiving digital ramp information, such as a look-up-table
- T: temperature
- BAND: channel frequency
- PCL: power class
- {kᵢ}: set of key values kᵢ
- {rᵢ}: set of power values in a power ramp R
- V_{BATT}: supply voltage
- V_{RAMP}: ramp voltage

## Claims

1. A power amplifier module (201; 301), comprising:
an amplifier circuit (103), responsive to a ramp voltage (V_{RAMP}), for amplifying an input signal (IS) to an output signal (OS); and **characterized in that**: said power amplifier module (201; 301) further comprises:
- means (223; 325) for receiving digital ramp information (DRI) corresponding to a power ramp; and
- digital-to-analog converting means (121), responsive to the means (223, 325) for receiving digital ramp information (DRI), for controlling the amplifier circuit (103) by setting the ramp voltage (V_{RAMP}).

2. A power amplifier module (201; 301) of claim 1, **wherein**:
the digital-to-analog converting means (121) comprises means for receiving a clock signal (CLOCK); and said digital-to-analog converting means (121) is responsive to said clock signal (CLOCK) received.

3. A power amplifier module (301) of claim 1 or 2, further **comprising**:
- a storage (325) for storing digital ramp information (DRI) for a plurality of power ramps;
- means (323) for selecting digital ramp information (DRI) for a power ramp from digital ramp information (DRI) stored; and
- means (323) for passing the digital ramp information (DRI) selected to the digital-to-analog converting means (121) as a set ({k}) of key values.

4. A power amplifier module (301) of claim 3, further **comprising:** means (131, 133) for measuring temperature (T) and/or battery supply voltage (V_{BATT}), electrically connected to means (323) for selecting digital ramp information (DRI); and wherein the means (323) for selecting digital ramp information (DRI) is responsive to temperature (T) and/or battery supply voltage (V_{BATT}) received from said means (131, 133) for measuring temperature (T) and/or battery supply voltage (V_{BATT}).

5. A power amplifier module (201; 301) according to any one of the preceding claims, **wherein**: the amplifier circuit (103); means (223; 325) for receiving digital ramp information (DRI) corresponding to a power ramp; and digital-to-analog converting means (121) are all integrated on a microchip.

6. A power amplifier module (301) of claim 5, **wherein**: the storage (325) for stroring digital ramp information (DRI) for a plurality of power ramps; the means for selecting digital ramp information (DRI); and the means (323) for passing the digital ramp information (DRI) to the digital-to-analog converting means (121) digital-to-analog meathe amplifier circuit (103); are further integrated on said microchip.

7. A power amplifier module (301) of claim 6, **wherein**: means (131, 133) for measuring temperature (T) and/or battery supply voltage (V_{BATT}) are further integrated on said microchip.

8. A mobile terminal (10), **comprising**:
- a base band unit (213) electrically connected to the power amplifier module (201);
- a power amplifier module (201; 301) according to any one of claims 1 to 4; and
- an antenna (107) electrically connected to the power amplifier module (201; 301); and **wherein**:
the base band unit (213) is adapted to pass information (BAND, PCL; DRI) responsive to channel frequency (BAND) and power class (PCL) to the power amplifier module (201; 301).

9. A mobile terminal (10) of claim 8, **wherein**: said information responsive to channel frequency (BAND) and power class (PCL) does not comprise digital ramp information (DRI) but comprises information on channel frequency (BAND) and power class (PCL).

10. A mobile terminal (10) of claim 8, **wherein**: said information (DRI) responsive to channel frequency (BAND) and power class (PCL) is digital ramp information (DRI).
